# EUROPEAN PATENT SPECIFICATION

(11) **EP 4 192 286 B1**
(45) Date of publication and mention of the grant of the patent: **29.04.2026**
(21) Application number: 21762004.6
(22) Date of filing: 09.08.2021
(51) Int. Cl.: A24F 40/40

(54) **AEROSOL GENERATION APPARATUS HAVING A CHASSIS COMPRISING A FLEXIBLE PART, AND CORRESPONDING ASSEMBLING METHOD**
AEROSOLERZEUGUNGSVORRICHTUNG MIT EINEM FLEXIBLEN GEHÄUSE MIT EINEM FLEXIBLEN TEIL UND ZUGEHÖRIGES MONTAGEVERFAHREN
APPAREIL DE GÉNÉRATION D'AÉROSOL AYANT UN CHÂSSIS COMPRENANT UNE PARTIE FLEXIBLE ET PROCÉDÉ D'ASSEMBLAGE CORRESPONDANT

(30) Priority: 10.08.2020 EP 20190216
(43) Date of publication of application: 14.06.2023
(73) Proprietor: JT International S.A., 1202 Genève (CH)
(72) Inventor: LOVEDAY, Peter, KT17 4ND Epsom Surrey (GB)
(74) Representative: Lavoix
(86) International application number: PCT/EP2021/072131
(87) International publication number: WO 2022/034005

(56) References cited:
- WO-A1-2016/028544
- WO-A1-2016/172023
- WO-A1-2017/163044
- WO-A2-2020/081849
- AU-A1- 2018 256 433
- US-A1- 2020 000 146
- US-A1- 2020 113 242

## Description

### FIELD OF THE INVENTION

The present invention deals with an aerosol generating apparatus.

The invention also deals with a method of assembling such an aerosol generating apparatus.

### BACKGROUND OF THE INVENTION

Different types of aerosol generation apparatuses are known in the art. Generally, such apparatuses comprise a storage portion for storing an aerosol forming precursor, for example comprising a liquid or a solid. A heating system is formed of one or more electrically activated resistive heating elements arranged to heat said precursor to generate the aerosol. The aerosol is released into a flow path extending between an inlet and outlet of the device. The outlet may be arranged as a mouthpiece, through which a user inhales for delivery of the aerosol.

In some aerosol generation apparatuses, the precursor is stored in a removable cartridge. Thus, when the precursor is consumed, the cartridge can be easily removed and replaced.

The aerosol generation apparatus comprises an outer casing, and internal components, such as a battery, a printed circuit board and at least a part of the heating system connected to the battery through the circuit board. The outer casing participates in the external design of the apparatus, may receive the consumable cartridge and is handled by the user while operating the aerosol generation apparatus. The outer casing protects the internal components from external influence and prevents the user from touching the internal components directly. The internal components are carefully positioned with respect to each other and, for some of them, in close proximity or in contact with the outer casing in order to allow smooth operation of the apparatus.

In some cases, the outer casing is in at least two pieces, which are then fixed on each other around the internal components.

However, in order to improve the external design of the apparatus, tubular outer casings in a single piece have been proposed, in metal or plastic. In this case, the internal components may be mounted on a chassis, to form an internal assembly, which is then inserted in the outer casing via an opening.

In order to allow insertion of the internal assembly, the opening in the outer casing is rather large and to facilitate the insertion, the internal section of the outer casing along the length is invariable. However, for the aesthetics of the apparatus or for design reasons, it would be desirable to reduce the size of the opening without compromising the delicate positioning of the internal components within the outer casing or restraining the interior volume of the outer casing.

Document US 2020/000146 describes an aerosol generating device which may include various modular components. The vaporizer device may include a first subassembly. The first subassembly may include a cartridge connector that secures a vaporizer cartridge to the vaporizer device and includes at least two receptacle contacts that electrically communicate with the vaporizer cartridge. The vaporizer device may include a second subassembly. The second subassembly may include a skeleton defining a rigid tray that retains at least a power source.

### SUMMARY OF THE INVENTION

An aim of the invention is thus to provide an aerosol generation apparatus comprising an outer casing with a smaller opening.

To this end, the invention relates to an aerosol generating apparatus according to claim 1.

Thanks to the above features, even if the internal assembly has a large cross section perpendicularly to the longitudinal axis that is larger than the cross section of the opening in a rest configuration, the internal assembly can be inserted through the opening in the flexed or retracted configuration.

According to some embodiments, the cavity has an extension along the transverse axis, said extension being larger than the extension of the opening, the cavity being configured for allowing the flexible part to elastically move with respect to the main part during said insertion from the flexed or retracted configuration to a work configuration, occupied when the internal assembly is in an inserted position, and in which the internal assembly has a third extension along the transverse axis that is larger than the extension of the opening.

Thanks to the above features, the flexible part may elastically expand with respect to the main part during said insertion from the flexed or retracted configuration to a work configuration. This allows giving the outer casing a shape which is larger in the middle than at its longitudinal extremities.

The opening is located at a first end of the outer casing along the longitudinal axis, the outer casing progressively or stepwise widening perpendicularly to the longitudinal axis from the first end towards a second end of the outer casing opposite the first end along the longitudinal axis.

Thanks to the above features, the outer casing may have various shapes, such as an ogival shape, from a side view.

According to some embodiments, the second end of the outer casing forms a bottom of the aerosol generating apparatus.

According to some embodiments, the outer casing is seamless.

Thanks to the above features, the outer casing has a very smooth shape and appearance. A seamless outer casing also ensures good mechanical resistance.

According to some embodiments, the flexible part comprises at least a base fixed on the main part of the chassis, and an arm extending from the base along the longitudinal axis.

Thanks to the above features, the flexible part is easy to fix on the main part of the chassis. It also provides the required flexibility and displacement of the flexible part in order to cooperate with the outer casing.

According to some embodiments, at least the arm is formed of an elastic electrically insulating material.

Thanks to the above features, the flexible part may serve as support for electric or electronic circuits or components.

According to some embodiments, in the work configuration, the arm is adapted to exert an elastic pressure on the outer casing, the outer casing having a radially inner surface with respect to the longitudinal axis, the arm preferably conforming to the radially inner surface in the work configuration.

Thanks to the above features, the flexible part of the chassis closely mates with the outer casing. This for example allows putting some of the internal components at a predefined small distance from the outer casing.

According to some embodiments, the arm has an extremity opposite the base along the longitudinal axis, the extremity defining an orifice, the aerosol generating apparatus comprising a cover adapted for closing an opening in the outer casing, said cover forming a hook adapted to cooperate with the orifice to retain the arm against the outer casing.

Thanks to the above features, the flexible part, or at least its extremity, may be fixed against the outer casing.

According to some embodiments, the flexible part further comprises an additional arm extending from the base along the longitudinal axis on the other side of the base with respect to the arm.

Thanks to the above features, the flexible part is longer than the arm.

According to some embodiments, said additional arm has an additional extremity opposite the base along the longitudinal axis, said additional extremity being fixed with respect to the main part of the chassis.

Thanks to the above features, the additional arm does not move with respect to the main part of the chassis, and has a predefined position with respect to the outer casing in the inserted position of the internal assembly.

According to some embodiments, the electronic printed circuit comprises at least a flexible portion mounted on the flexible part.

Thanks to the above features, the flexible portion of the electronic printed circuit is in a close vicinity with the outer casing.

According to some embodiments, the flexible part has a radially outer face with respect to the longitudinal axis, the radially outer face forming a recess housing said at least one flexible portion of electronic printed circuit, said at least one flexible portion of electronic printed circuit being sunken in the recess so as to prevent scratching of the electronic printed circuit by the outer casing during said insertion.

Thanks to the above features, the flexible portion of the electronic printed circuit is protected from being scratched by a border of the opening during insertion of the internal assembly in the outer casing.

The invention also relates to a method of assembling an aerosol generating apparatus according to claim 13.

### BRIEF DESCRIPTION OF THE DRAWINGS

The invention and its advantages will be better understood upon reading the following description, given solely by way of non-limiting example and made with reference to the appended drawings, in which:
- Figure 1 is a perspective view of an aerosol generation apparatus according to the invention;
- Figure 2 is an exploded view of the aerosol generation apparatus shown in Figure 1;
- Figure 3 is an exploded view of a part of the aerosol generation apparatus shown in Figures 1 and 2; and
- Figure 4 is a cross-sectional view of a part of the aerosol generation apparatus shown in Figure 1 and 2 according to plan A shown in Figure 1.

### DETAILED DESCRIPTION OF THE INVENTION

The invention is not limited to the details of construction set forth in the following description. It will be apparent to those skilled in the art having the benefit of the present disclosure that the invention is capable of other embodiments and of being practiced or being carried out in various ways.

As used herein, the term "aerosol generation apparatus" or "apparatus" may include a vaping device to deliver an aerosol to a user, including an aerosol for vaping, by means of aerosol generating unit (e.g. an aerosol generating element which generates vapor which condenses into an aerosol before delivery to an outlet of the device at, for example, a mouthpiece, for inhalation by a user). The device may be portable. "Portable" may refer to the device being for use when held by a user. The device may be adapted to generate amounts of aerosol, e.g. by activating a heater system for a variable amount of time (as opposed to a metered dose of aerosol) and/or for a predefined number of inhalations (i.e. puffs), which can be controlled by a trigger. The trigger may be user activated, such as a vaping button and/or inhalation sensor (e.g. pressure sensor or microphone). The inhalation sensor may be sensitive to the strength of inhalation as well as the duration of inhalation to enable a variable amount of vapor to be provided (so as to mimic the effect of smoking a conventional combustible smoking article such as a cigarette, cigar or pipe, etc.). The device may include a temperature regulation control to drive the temperature of the heater and/or the heated aerosol generating substance (aerosol pre-cursor) to a specified target temperature and thereafter to maintain the temperature at the target temperature that enables efficient generation of aerosol.

As used herein, the term "**aerosol**" may include a suspension of precursor as one or more of: solid particles; liquid droplets; gas. Said suspension may be in a gas including air. Aerosol herein may generally refer to/include a vapor. Aerosol may include one or more components of the precursor.

As used herein, the term "**aerosol-forming precursor**" or "**precursor**" or "**aerosol-forming substance**" or "**substance**" may refer to one or more of a: liquid; solid; gel; mousse; foam or other substances. The precursor may be processable by the heating system of the device to form an aerosol as defined herein. The precursor may comprise one or more of: nicotine; caffeine or other active components. The active component may be carried with an aerosol former, which may be a liquid. The aerosol former may include propylene glycol or glycerin. A flavoring may also be present. The flavoring may include Ethylvanillin (vanilla), menthol, Isoamyl acetate (banana oil) or similar. A solid aerosol forming substance may be in the form of a rod, which contains processed tobacco material, a crimped sheet or oriented strips of reconstituted tobacco (RTB).

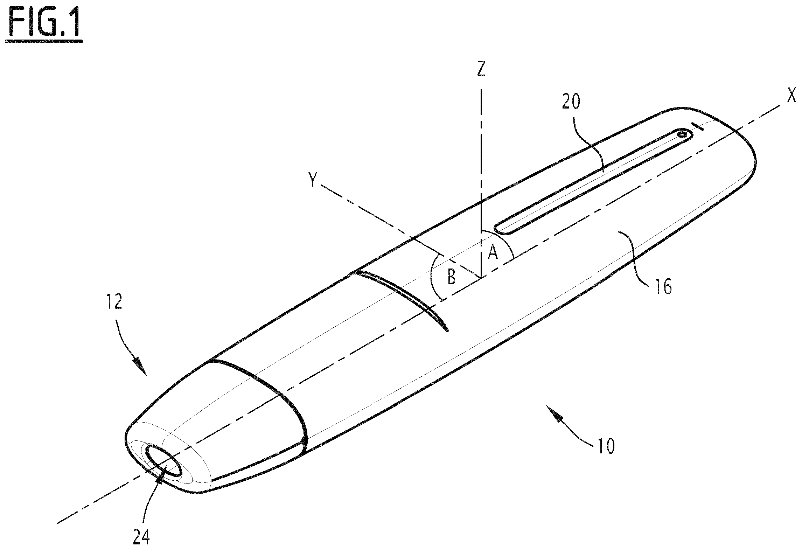

An aerosol generation apparatus 10 according to the invention will now be described with reference to Figures 1 to 4.

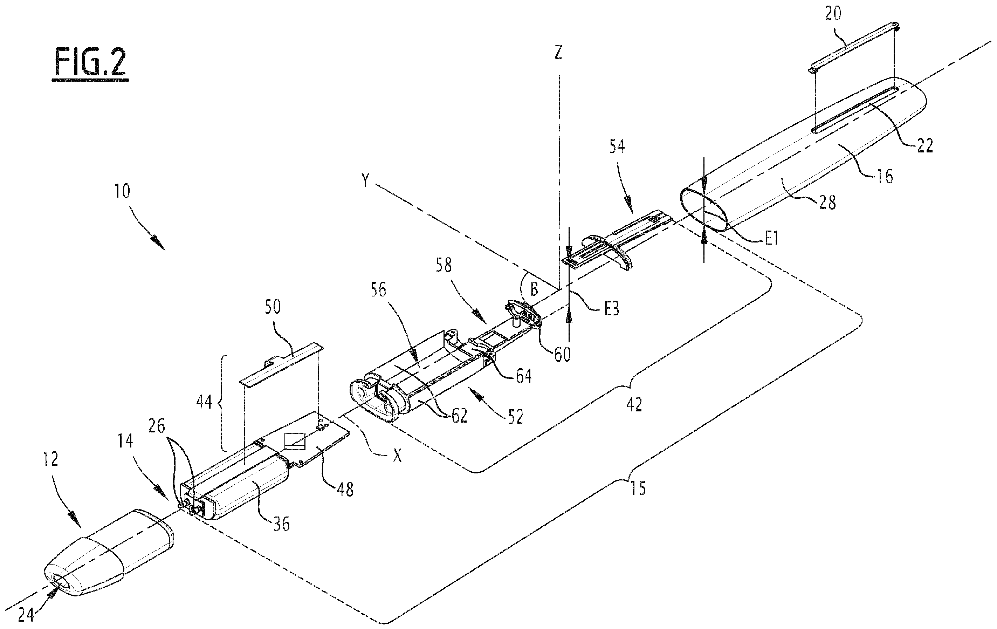

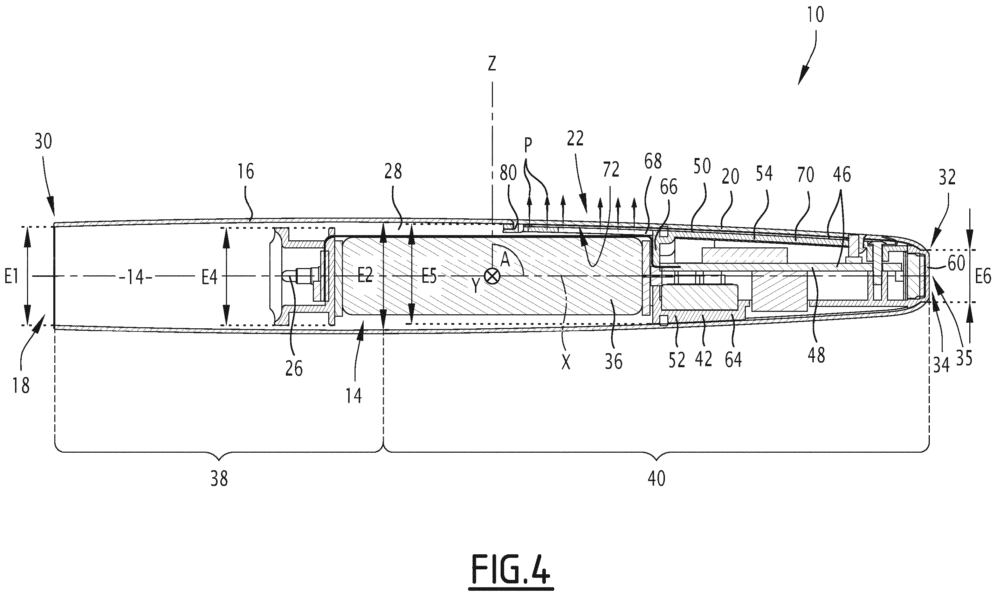

In this example, the aerosol generation apparatus 10 is designed to operate with a removable cartridge 12 (Figures 1 and 2) received in a payload compartment 14 shown in Figure 4. The aerosol generation apparatus 10 extends along a longitudinal axis X. As shown in Figure 1, the aerosol generation apparatus 10 is advantageously elongated along the longitudinal axis X. For example, the aerosol generation apparatus 10 is at least five times longer along the longitudinal axis X than along a first transverse axis Y perpendicular to the longitudinal axis X, and advantageously at least ten times longer along the longitudinal axis X than along a second transverse axis Z perpendicular to the longitudinal axis X and to the first transverse axis Y. Cross sections of the aerosol generation apparatus 10 perpendicularly to the longitudinal axis X for example have an oval or oblong shape.

As best seen in Figure 2, the apparatus 10 comprises an internal assembly 15, and an outside casing 16 defining an opening 18 for insertion of the internal assembly in the outer casing along the longitudinal axis X. The apparatus 10 advantageously comprises a cover 20 closing a second opening 22 defined by the outer casing 16.

The cartridge 12 comprises a precursor storage portion able to store a precursor and at least a heater (known in itself and not shown) able to heat the precursor to generate aerosol. The aerosol is evacuated through a vapor outlet 24 (Figure 1). The heater of the cartridge 12 is connected to a power source of the device 10 through a pair of contacts arranged in both the cartridge 12 and the aerosol generation device 10. A pair of contacts 26 arranged in the payload compartment 14 is shown in Figures 2 and 4.

The outer casing 16 is elongated along the longitudinal axis X and defines an internal cavity 28 adapted to receive the internal assembly 15. At a first end 30 along the longitudinal axis X, the outer casing 16 defines the opening 18 which is for example perpendicular to the longitudinal axis X. At a second end 32 apposite the first end 30 along the longitudinal axis X, for example forming a bottom 34 of the apparatus 10, the outer casing 16 advantageously forms a charging opening 35 or pins (not shown) to charge a battery 36 of the apparatus 10.

The outer casing 16 is advantageously made of a single piece, for example molded or obtained by welding parts (e.g. anodized aluminium). The outer casing 16 is advantageously seamless. The outer casing 16 is for example symmetric with respect to plane A (defined by the longitudinal axis X and the second transverse axis Z) and advantageously with respect to a plan B defined by the longitudinal axis X and the first transverse axis Y. At any location along the longitudinal axis X, the outer casing 16 is for example larger along the first transverse axis Y than along the second transverse axis Z. The opening 18 has an extension E1 along the second transverse axis Z.

By "extension of an object along an axis", it is for example meant the smallest distance between too planes perpendicular to said axis and located on either sides of the object.

For example, the cavity 28 longitudinally comprises a first section 38 which transversely widens from the first end 30 towards the second end 32, and a second section 40 which transversely shortens towards the second end 32. The widening and shortening occur at least along one of the first transverse axis Y and the second transverse axis Z, for example along both transverse axes. Between the first section 38 and the second section 40, the cavity 28 has an extension E2 along the second transverse axis Z that is larger than the extension E1 of the opening 18.

Other than the battery 36, the internal assembly 15 notably comprises a chassis 42, and an electronic module 44 adapted to control the apparatus 10. The electronic module 44 comprises an electronic printed circuit 46 having a printed circuit board 48 and a flexible portion 50 electrically connected to the printed circuit board.

The chassis 42 comprises a main part 52, and a flexible part 54 mounted on the main part. The main part 52 defines, successively along the longitudinal axis X, a battery compartment 56 able to receive the battery 36, and a circuit compartment 58 able to receive the printed circuit board 48. The main part for examples includes a rear portion 60 transversely extending in the charging opening 35 in the inserted position of the internal assembly 15 shown in Figure 4. For example, the main part 54 comprises two lateral members 62 abutting against the outer casing 16 along the first transverse axis Y, and another lateral member 64 abutting against the outer casing 16 along the second transverse axis Z in the inserted position.

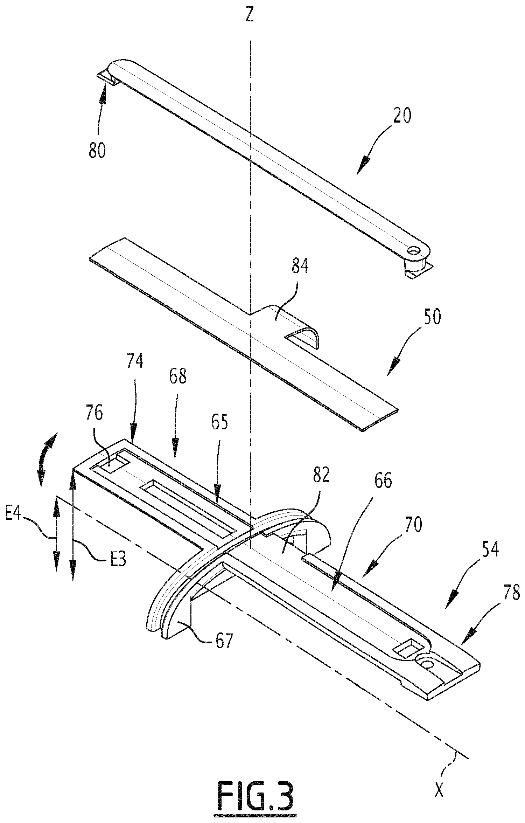

The flexible part 54 is elastically moveable with respect to the main part 52 between a rest configuration (shown in Figure 2 in an exploded manner), in which the internal assembly 15 has a first extension E3 along the transverse axis Z that is larger than the extension E1 of the opening 18, and a flexed or retracted configuration (not shown but symbolized on Figures 3 and 4), in which the internal assembly has a second extension E4 along the transverse axis Z that is smaller than the extension E1, so as to allow insertion of the internal assembly 15 in the cavity 28 via the opening 18 along the longitudinal axis X. The rest configuration is such that, if the flexible part 54 was maintained in position without ability to flex in the direction of the second transverse axis Z, the internal assembly 15 could not enter the cavity 28.

Advantageously, the flexible part 54 is elastically moveable with respect to the main part 52 from the flexed or retracted configuration, to a work configuration (shown in Figure 4), occupied when the internal assembly 15 is in the inserted position, and in which the internal assembly has a third extension E5 along the transverse axis Z that is larger than the extension E1 of the opening 16. According to a particular embodiment, the work configuration is analogous to the rest configuration, i.e. the third extension E5 is approximately equal to the first extension E3. The flexible part 54 has a radially outer face 65 with respect to the longitudinal axis X, the radially outer face 65 forming a recess 66 housing the flexible portion 50 of the electronic printed circuit 46. The flexible part 54 for example comprises a base 67 extending along the first transverse axis Y and fixed on the main part 52 (at least in the inserted position), an arm 68 longitudinally extending from the base, and advantageously an additional arm 70 longitudinally extending from the base on the other side of the base with respect to said arm 68. In a particular embodiment, the third extension E5 is larger than an extension E6 of the charging opening 35 or the bottom 34 of the outer casing 16 at the second end 32.

In the rest configuration, the arm 68 is a cantilevered member. The arm 68 is adapted to flex along the second transverse axis Z with respect to the main part 52. In the inserted position, the arm 68 is advantageously directed toward the opening 18. According a particular embodiment, in the work configuration, the arm 68 is adapted to exert an elastic pressure P on the outer casing 16. In the work configuration, the arm 68 preferably conforms to a radially inner surface 72 of the outer casing 16 with respect to the longitudinal axis X. The arm 68 is advantageously formed of an elastic electrically insulating material, for example PEEK (polyether ether ketone). The arm 68 has an extremity 74 opposite the base 66 along the longitudinal axis X, the extremity for example defining an orifice 76. The extremity 74 is closer to the longitudinal axis X in the flexed or retracted configuration than in the rest configuration or in the work configuration.

The additional arm 70 has an additional extremity 78 opposite the base 67 along the longitudinal axis X, said additional extremity may be fixed with respect to the main part 52 of the chassis 42. The arm 68 and the additional arm 70 altogether longitudinally extend between the battery compartment 56 and the circuit compartment 58 in the inserted position, for example from at least ½ of the battery compartment's length to at least ¾ of the circuit compartment's length.

Seen along the longitudinal axis X, the base 67 for example has an arched shape adapted for mating with the radially inner surface 72 of the outer casing 16. The base 67 is for example located between the battery compartment 56 and the circuit compartment 58 along the longitudinal axis X.

The cover 20 for example forms a hook 80 adapted to cooperate with the orifice 76 to retain the arm 68 against the outer casing 16. Advantageously, the cover 20 is made of a material having a high dielectric constant.

The flexible portion 50 forms a capacitive panel used to control operation of the apparatus 10. Particularly, the flexible portion 50 is able to ensure a capacitive touch function of the apparatus 10. The flexible portion 50 is advantageously sunken in the recess 66 so as to prevent scratching of the electronic printed circuit 46 by the outer casing 16 during the insertion. The flexible portion 50 is for example adapted to detect touch movements of a user (not shown) on and/or along the cover 20. The flexible portion 50 is adhered to the base of the recess 66. In particular embodiments, the flexible portion may include antennas, capacitive sensors, LED, contacts or user interface components. The recess 66 for example extends longitudinally on both the arm 68 and the additional arm 70. The recess 66 advantageously forms a side opening 82 for a connecting member 84 of the flexible portion 50 extending along the first transverse axis Y.

A method of assembling the apparatus 10 will now be described.

At first, the internal assembly 15 is provided. In particular, the battery 36 and the printed circuit board 48 are mounted on the main part 52 of the chassis 42. The flexible part 54 of the chassis is mounted on the main part 52. The flexible portion 50 of the electronic printed circuit 46 is fixed, for example glued, to the flexible part 54 in the recess 66. At this stage, the internal assembly 15 is outside the outer casing 16, and the flexible part 54 is in the rest configuration.

Then the internal assembly 15 is inserted in the cavity 28 along the longitudinal axis X through the opening 18. During the insertion, the outer casing 16 presses on the arm 68 of the flexible part 54, and deflects from the rest configuration to the flexed or retracted configuration, for example when the extremity 74 reaches the opening 18. In other words, during the insertion, the flexible part 54 elastically moves with respect to the main part 52 in order to decrease the extension of the internal assembly 15 from the first extension E3 (larger than E1) to the second extension E4 (smaller than E1).

In a particular embodiment, the flexible part 54 is fixed in the flexed or retracted configuration, for example by a latch (not shown), before insertion, and the latch is released after insertion.

During the insertion, the base 67 advantageously goes through the opening 18 before the extremity 74 of the arm 68, so that the movement from the rest configuration to the flexed or retracted configuration is a consequence of the insertion movement. The flexible portion 50 being sunken in the recess 66, the flexible portion is protected from scratches from the outer casing 16.

Advantageously, when the internal assembly 15 is in the inserted position, the flexible part 54 elastically releases from the flexed or retracted configuration to the work configuration, with a third extension E5 again larger than the extension E1. This allows putting the flexible portion 50 of the electronic printed circuit 46 is close contact with the cover 20.

Thanks to the above features, the opening 18 of apparatus 10 is smaller, while allowing insertion of the internal assembly 15 in the cavity 28 and adequate positioning of the internal assembly, in particular of the flexible portion 50 of electronic printed circuit 46.

The invention is defined by the claims which follow.

## Claims

1. An aerosol generating apparatus (10) comprising:
- an internal assembly (15) comprising a chassis (42), and an electronic printed circuit (46) mounted on the chassis (42), and
- an outer casing (16) extending along a longitudinal axis (X) and defining an opening (18) for insertion of the internal assembly (15) along the longitudinal axis (X) in a cavity (28) formed by the outer casing (16),
wherein the chassis (42) comprises a main part (52), and a flexible part (54) mounted on the main part (52) and elastically moveable with respect to the main part (52) between a rest configuration, in which the internal assembly (15) has a first extension (E3) along a transverse axis (Z) perpendicular to the longitudinal axis (X) that is larger than an extension (E1) of the opening (18) along the transverse axis (Z), and a flexed or retracted configuration, in which the internal assembly (15) has a second extension (E4) along the transverse axis (Z) that is smaller than the extension (E1) of the opening (18), so as to allow said insertion,
**characterized in that**:
- the opening (18) is located at a first end (30) of the outer casing (16) along the longitudinal axis (X), the outer casing (16) progressively or stepwise widening perpendicularly to the longitudinal axis (X) from the first end (30) towards a second end (32) of the outer casing (16) opposite the first end (30) along the longitudinal axis (X), and
- the cavity (28) longitudinally comprises a first section (38) which transversely widens from the first end (30) towards the second end (32), and a second section (40) which transversely shortens towards the second end (32).

2. Aerosol generating apparatus (10) according to claim 1, wherein the cavity (28) has an extension (E4) along the transverse axis (Z), said extension (E4) being larger than the extension (E1) of the opening (18), the cavity (28) being configured for allowing the flexible part (54) to elastically move with respect to the main part (52) during said insertion from the flexed or retracted configuration to a work configuration, occupied when the internal assembly is in an inserted position, and in which the internal assembly (15) has a third extension (E5) along the transverse axis (Z) that is larger than the extension (E1) of the opening (18).

3. Aerosol generating apparatus (10) according to claim 1 or 2, wherein the second end (32) of the outer casing (16) forms a bottom (34) of the aerosol generating apparatus (10).

4. Aerosol generating apparatus (10) according to any one of claims 1 to 3, wherein the outer casing (16) is seamless.

5. Aerosol generating apparatus (10) according to any one of claims 1 to 4, wherein the flexible part (54) comprises at least a base (67) fixed on the main part (52) of the chassis (42), and an arm (68) extending from the base (67) along the longitudinal axis (X).

6. Aerosol generating apparatus (10) according to claim 5, wherein at least the arm (68) is formed of an elastic electrically insulating material.

7. Aerosol generating apparatus (10) according to claim 5 or 6, wherein, in the work configuration, the arm (68) is adapted to exert an elastic pressure (P) on the outer casing (16), the outer casing (16) having a radially inner surface (72) with respect to the longitudinal axis (X), the arm (68) preferably conforming to the radially inner surface (72) in the work configuration.

8. Aerosol generating apparatus (10) according to any one of claims 5 to 7, wherein the arm (68) has an extremity (74) opposite the base (67) along the longitudinal axis (X), the extremity (74) defining an orifice (76), the aerosol generating apparatus (10) comprising a cover (20) adapted for closing an opening (22) in the outer casing (16), said cover (20) forming a hook (80) adapted to cooperate with the orifice (76) to retain the arm (68) against the outer casing (16).

9. Aerosol generating apparatus (10) according to any one of claims 5 to 8, wherein the flexible part (54) further comprises an additional arm (70) extending from the base (67) along the longitudinal axis (X) on the other side of the base (67) with respect to the arm (68).

10. Aerosol generating apparatus (10) according to claim 9, wherein said additional arm (70) has an additional extremity (78) opposite the base (67) along the longitudinal axis (X), said additional extremity (78) being fixed with respect to the main part (52) of the chassis (42).

11. Aerosol generating apparatus (10) according to any one of claims 1 to 10, wherein the electronic printed circuit (46) comprises at least a flexible portion (50) mounted on the flexible part (54).

12. Aerosol generating apparatus (10) according to claim 11, wherein the flexible part (54) has a radially outer face (65) with respect to the longitudinal axis (X), the radially outer face (65) forming a recess (66) housing said at least one flexible portion (50) of electronic printed circuit (46), said at least one flexible portion (50) of electronic printed circuit (46) being sunken in the recess (66) so as to prevent scratching of the electronic printed circuit (46) by the outer casing (16) during said insertion.

13. Method of assembling an aerosol generating apparatus (10), comprising the following steps:
- providing an internal assembly (15) comprising a chassis (42), and an electronic printed circuit (46) mounted on the chassis (42), the chassis (42) comprising a main part (52), and a flexible part (54) mounted on the main part (52),
- providing an outer casing (16) extending along a longitudinal axis (X) and defining an opening (18) for insertion of the internal assembly (15) along the longitudinal axis (X) in a cavity (28) defined by the outer casing (16), wherein the opening (18) is located at a first end (30) of the outer casing (16) along the longitudinal axis (X), the outer casing (16) progressively or stepwise widening perpendicularly to the longitudinal axis (X) from the first end (30) towards a second end (32) of the outer casing (16) opposite the first end (30) along the longitudinal axis (X), the cavity (28) longitudinally comprising a first section (38) which transversely widens from the first end (30) towards the second end (32), and a second section (40) which transversely shortens towards the second end (32),
- inserting the internal assembly (15) in the cavity (28) along the longitudinal axis (X) through the opening (18), and
- during or before said the inserting step, elastically moving the flexible part (54) with respect to the main part (52) between a rest configuration, in which the internal assembly (15) has a first extension (E3) along a transverse axis (Z) perpendicular to the longitudinal axis (X) that is larger than an extension (E1) of the opening (18) along the transverse axis (Z), and a flexed or retracted configuration, in which the internal assembly (15) has a second extension (E3) along the transverse axis (Z) that is smaller than the extension (E1) of the opening (18), so as to allow said insertion.

## Patentansprüche

1. Aerosolerzeugungsvorrichtung (10), umfassend:
- eine interne Anordnung (15), umfassend ein Gerüst (42) und eine Leiterplatte (46), die an dem Gerüst (42) montiert ist, und
- ein äußeres Gehäuse (16), das sich entlang einer Längsachse (X) erstreckt und eine Öffnung (18) zum Einsetzen der internen Anordnung (15) entlang der Längsachse (X) in einen von dem äußeren Gehäuse (16) gebildeten Hohlraum (28) definiert,
wobei das Gerüst (42) einen Hauptteil (52) und einen flexiblen Teil (54) umfasst, der auf dem Hauptteil (52) montiert ist und in Bezug auf den Hauptteil (52) elastisch zwischen einer Ruhekonfiguration, in der die innere Anordnung (15) eine erste Erstreckung (E3) entlang einer Querachse (Z) senkrecht zu der Längsachse (X) aufweist, die größer ist als eine Erstreckung (E1) der Öffnung (18) entlang der Querachse (Z), und einer gebogenen oder eingezogenen Konfiguration, in der die interne Anordnung (15) eine zweite Erstreckung (E4) entlang der Querachse (Z) aufweist, die kleiner ist als die Erstreckung (E1) der Öffnung (18) bewegbar ist, um das Einführen zu ermöglichen,
**dadurch gekennzeichnet, dass**:
- die Öffnung (18) an einem ersten Ende (30) des äußeren Gehäuses (16) entlang der Längsachse (X) angeordnet ist, wobei sich das äußere Gehäuse (16) senkrecht zu der Längsachse (X) von dem ersten Ende (30) zu einem zweiten Ende (32) des äußeren Gehäuses (16) gegenüber dem ersten Ende (30) entlang der Längsachse (X) fortschreitend oder stufenweise verbreitert, und
- der Hohlraum (28) in Längsrichtung einen ersten Abschnitt (38), der sich von dem ersten Ende (30) zu dem zweiten Ende (32) hin in Querrichtung erweitert, und einen zweiten Abschnitt (40), der sich in Querrichtung zu dem zweiten Ende (32) verkürzt, umfasst.

2. Aerosolerzeugungsvorrichtung (10) nach Anspruch 1, wobei der Hohlraum (28) eine Erstreckung (E4) entlang der Querachse (Z) aufweist, wobei die Erstreckung (E4) größer ist als die Erstreckung (E1) der Öffnung (18), wobei der Hohlraum (28) konfiguriert ist, um dem flexiblen Teil (54) zu ermöglichen, sich in Bezug auf den Hauptteil (52) während des Einsetzens von der gebogenen oder zurückgezogenen Konfiguration elastisch in eine Arbeitskonfiguration zu bewegen, die eingenommen wird, wenn die innere Anordnung in einer eingeführten Position ist, und in der die innere Anordnung (15) eine dritte Erstreckung (E5) entlang der Querachse (Z) aufweist, die größer ist als die Erstreckung (E1) der Öffnung (18).

3. Aerosolerzeugungsvorrichtung (10) nach Anspruch 1 oder 2, wobei das zweite Ende (32) des äußeren Gehäuses (16) einen Boden (34) der Aerosolerzeugungsvorrichtung (10) bildet.

4. Aerosolerzeugungsgerät (10) nach einem der Ansprüche 1 bis 3, wobei das äußere Gehäuse (16) nahtlos ist.

5. Aerosolerzeugungsvorrichtung (10) nach einem der Ansprüche 1 bis 4, wobei der flexible Teil (54) mindestens eine Basis (67), die an dem Hauptteil (52) des Gerüst (42) befestigt ist, und einen Arm (68), der sich von der Basis (67) entlang der Längsachse (X) erstreckt, umfasst.

6. Aerosolerzeugungsgerät (10) nach Anspruch 5, wobei zumindest der Arm (68) aus einem elastischen, elektrisch isolierenden Material gebildet ist.

7. Aerosolerzeugungsvorrichtung (10) nach Anspruch 5 oder 6, wobei der Arm (68) in der Arbeitskonfiguration angepasst ist, um einen elastischen Druck (P) auf das äußere Gehäuse (16) auszuüben, wobei das äußere Gehäuse (16) in Bezug auf die Längsachse (X) eine radial innere Oberfläche (72) aufweist, wobei der Arm (68) in der Arbeitskonfiguration vorzugsweise an die radial innere Oberfläche (72) angepasst ist.

8. - Aerosolerzeugungsvorrichtung (10) nach einem der Ansprüche 5 bis 7, wobei der Arm (68) ein Ende (74) gegenüber der Basis (67) entlang der Längsachse (X) aufweist, wobei das Ende (74) eine Öffnung (76) definiert, die Aerosolerzeugungsvorrichtung (10) umfassend eine Abdeckung (20), die zum Verschließen einer Öffnung (22) in dem äußeren Gehäuse (16) angepasst ist, wobei die Abdeckung (20) einen Haken (80) bildet, der angepasst ist, um mit der Öffnung (76) zusammenzuwirken, um den Arm (68) gegen das äußere Gehäuse (16) zu halten.

9. Aerosolerzeugungsvorrichtung (10) nach einem der Ansprüche 5 bis 8, wobei der flexible Teil (54) ferner einen zusätzlichen Arm (70) umfasst, der sich von der Basis (67) entlang der Längsachse (X) auf der anderen Seite der Basis (67) in Bezug auf den Arm (68) erstreckt.

10. - Aerosolerzeugungsvorrichtung (10) nach Anspruch 9, wobei der zusätzliche Arm (70) ein zusätzliches Ende (78) gegenüber der Basis (67) entlang der Längsachse (X) aufweist, wobei das zusätzliche Ende (78) in Bezug auf den Hauptteil (52) des Gerüsts (42) feststehend ist.

11. Aerosolerzeugungsvorrichtung (10) nach einem der Ansprüche 1 bis 10, wobei die elektronische Leiterplatte (46) mindestens einen flexiblen Abschnitt (50) umfasst, der an dem flexiblen Teil (54) montiert ist.

12. Aerosolerzeugungsvorrichtung (10) nach Anspruch 11, wobei der flexible Teil (54) eine radial äußere Fläche (65) in Bezug auf die Längsachse (X) aufweist, wobei die radial äußere Fläche (65) eine Aussparung (66) bildet, die den mindestens einen flexiblen Abschnitt (50) der elektronischen Leiterplatte (46) aufnimmt, wobei der mindestens eine flexible Abschnitt (50) der elektronischen Leiterplatte (46) in der Aussparung (66) versenkt ist, um ein Zerkratzen der elektronischen Leiterplatte (46) durch das äußere Gehäuse (16) während des Einführens zu verhindern.

13. Zusammenbauverfahren einer Aerosolerzeugungsvorrichtung (10), umfassend die folgenden Schritte:
- Bereitstellen einer internen Anordnung (15), umfassend ein Gerüst (42) und eine elektronische Leiterplatte (46), die an dem Gerüst (42) montiert ist, wobei das Gerüst (42) einen Hauptteil (52) und einen flexiblen Teil (54) umfasst, der an dem Hauptteil (52) montiert ist,
- Bereitstellen eines äußeren Gehäuses (16), das sich entlang einer Längsachse (X) erstreckt und eine Öffnung (18) zum Einsetzen der internen Anordnung (15) entlang der Längsachse (X) in einen durch das äußere Gehäuse (16) definierten Hohlraum (28) definiert, wobei sich die Öffnung (18) an einem ersten Ende (30) des äußeren Gehäuses (16) entlang der Längsachse (X) befindet, das äußere Gehäuse (16) sich progressiv oder stufenweise senkrecht zu der Längsachse (X) von dem ersten Ende (30) zu einem zweiten Ende (32) des äußeren Gehäuses (16) gegenüber dem ersten Ende (30) entlang der Längsachse (X) verbreitert, wobei der Hohlraum (28) in Längsrichtung einen ersten Abschnitt (38), der sich in Querrichtung von dem ersten Ende (30) zu dem zweiten Ende (32) verbreitert, und einen zweiten Abschnitt (40), der sich in Querrichtung zu dem zweiten Ende (32) verkürzt, umfasst,
- Einsetzen der internen Anordnung (15) in den Hohlraum (28) entlang der Längsachse (X) durch die Öffnung (18), und
- während oder vor dem Einführungsschritt, elastisches Bewegen des flexiblen Teils (54) in Bezug auf den Hauptteil (52) zwischen einer Ruhekonfiguration, in der die innere Anordnung (15) eine erste Erstreckung (E3) entlang einer Querachse (Z) senkrecht zu der Längsachse (X) aufweist, die größer ist als eine Erstreckung (E1) der Öffnung (18) entlang der Querachse (Z), und einer gebogenen oder eingezogenen Konfiguration, in der die innere Einheit (15) eine zweite Erstreckung (E3) entlang der Querachse (Z) aufweist, die kleiner ist als die Erstreckung (E1) der Öffnung (18) bewegbar ist, um das Einführen zu ermöglichen.

## Revendications

1. Appareil générateur d'aérosol (10) comprenant :
- un ensemble interne (15) comprenant un châssis (42) et un circuit imprimé électronique (46) monté sur le châssis (42), et
- un boîtier externe (16) s'étendant le long d'un axe longitudinal (X) et définissant une ouverture (18) pour l'insertion de l'ensemble interne (15) le long de l'axe longitudinal (X) dans une cavité (28) formée par le boîtier externe (16),
dans lequel le châssis (42) comprend une partie principale (52) et une partie flexible (54) montée sur la partie principale (52) et mobile élastiquement par rapport à la partie principale (52) entre une configuration de repos, dans laquelle l'ensemble interne (15) a une première extension (E3) le long d'un axe transversal (Z) perpendiculaire à l'axe longitudinal (X) qui est plus grande qu'une extension (E1) de l'ouverture (18) le long de l'axe transversal (Z), et une configuration fléchie ou rétractée, dans laquelle l'ensemble interne (15) présente une deuxième extension (E4) le long de l'axe transversal (Z) qui est inférieure à l'extension (E1) de l'ouverture (18), de manière à permettre ladite insertion,
**caractérisé en ce que** :
- l'ouverture (18) est située à une première extrémité (30) du boîtier externe (16) le long de l'axe longitudinal (X), le boîtier externe (16) s'élargissant progressivement ou par paliers perpendiculairement à l'axe longitudinal (X) à partir de la première extrémité (30) vers une seconde extrémité (32) du boîtier externe (16) opposée à la première extrémité (30) le long de l'axe longitudinal (X), et
- la cavité (28) comprend longitudinalement une première section (38) qui s'élargit transversalement à partir de la première extrémité (30) vers la seconde extrémité (32), et une seconde section (40) qui se raccourcit transversalement vers la seconde extrémité (32).

2. Appareil générateur d'aérosol (10) selon la revendication 1, dans lequel la cavité (28) présente une extension (E4) le long de l'axe transversal (Z), ladite extension (E4) étant supérieure à l'extension (E1) de l'ouverture (18), la cavité (28) étant configurée pour permettre à la partie flexible (54) de se déplacer élastiquement par rapport à la partie principale (52) au cours de ladite insertion depuis la configuration fléchie ou rétractée jusqu'à une configuration de travail, occupée lorsque l'ensemble interne est en position insérée, et dans laquelle l'ensemble interne (15) présente une troisième extension (E5) le long de l'axe transversal (Z) qui est plus grande que l'extension (E1) de l'ouverture (18).

3. Appareil générateur d'aérosol (10) selon la revendication 1 ou 2, dans lequel la seconde extrémité (32) du boîtier externe (16) forme un fond (34) de l'appareil générateur d'aérosol (10).

4. Appareil générateur d'aérosol (10) selon l'une quelconque des revendications 1 à 3, dans lequel le boîtier externe (16) est sans soudure.

5. Appareil générateur d'aérosol (10) selon l'une quelconque des revendications 1 à 4, dans lequel la partie flexible (54) comprend au moins une base (67) fixée sur la partie principale (52) du châssis (42), et un bras (68) s'étendant à partir de la base (67) le long de l'axe longitudinal (X).

6. Appareil générateur d'aérosol (10) selon la revendication 5, dans lequel au moins le bras (68) est formé d'un matériau élastique électriquement isolant.

7. Appareil générateur d'aérosol (10) selon la revendication 5 ou 6, dans lequel, dans la configuration de travail, le bras (68) est adapté pour exercer une pression élastique (P) sur le boîtier externe (16), le boîtier externe (16) présentant une surface interne radiale (72) par rapport à l'axe longitudinal (X), le bras (68) se conformant de préférence à la surface interne radiale (72) dans la configuration de travail.

8. Appareil générateur d'aérosol (10) selon l'une quelconque des revendications 5 à 7, dans lequel le bras (68) présente une extrémité (74) opposée à la base (67) le long de l'axe longitudinal (X), l'extrémité (74) définissant un orifice (76), l'appareil générateur d'aérosol (10) comprenant un couvercle (20) adapté pour fermer une ouverture (22) dans le boîtier externe (16), ledit couvercle (20) formant un crochet (80) adapté pour coopérer avec l'orifice (76) afin de retenir le bras (68) contre le boîtier externe (16).

9. Appareil générateur d'aérosol (10) selon l'une quelconque des revendications 5 à 8, dans lequel la partie flexible (54) comprend en outre un bras supplémentaire (70) s'étendant à partir de la base (67) le long de l'axe longitudinal (X) de l'autre côté de la base (67) par rapport au bras (68).

10. Appareil générateur d'aérosol (10) selon la revendication 9, dans lequel ledit bras supplémentaire (70) a une extrémité supplémentaire (78) opposée à la base (67) le long de l'axe longitudinal (X), ladite extrémité supplémentaire (78) étant fixée par rapport à la partie principale (52) du châssis (42).

11. Appareil générateur d'aérosol (10) selon l'une quelconque des revendications 1 à 10, dans lequel le circuit imprimé électronique (46) comporte au moins une portion flexible (50) montée sur la partie flexible (54).

12. Appareil générateur d'aérosol (10) selon la revendication 11, dans lequel la partie flexible (54) présente une face externe radiale (65) par rapport à l'axe longitudinal (X), la face externe radiale (65) formant un évidement (66) abritant ladite au moins une portion flexible (50) du circuit imprimé électronique (46), ladite au moins une portion flexible (50) du circuit imprimé électronique (46) étant enfoncée dans l'évidement (66) de façon à éviter que le circuit imprimé électronique (46) ne soit rayé par le boîtier externe (16) lors de ladite insertion.

13. Procédé d'assemblage d'un appareil générateur d'aérosol (10), comprenant les étapes suivantes :
- fourniture d'un ensemble interne (15) comprenant un châssis (42), et un circuit imprimé électronique (46) monté sur le châssis (42), le châssis (42) comprenant une partie principale (52), et une partie flexible (54) montée sur la partie principale (52),
- fourniture d'un boîtier externe (16) s'étendant le long d'un axe longitudinal (X) et définissant une ouverture (18) pour l'insertion de l'ensemble interne (15) le long de l'axe longitudinal (X) dans une cavité (28) définie par le boîtier externe (16), dans lequel l'ouverture (18) est située à une première extrémité (30) du boîtier externe (16) le long de l'axe longitudinal (X), le boîtier externe (16) s'élargissant progressivement ou par paliers perpendiculairement à l'axe longitudinal (X) de la première extrémité (30) vers une seconde extrémité (32) du boîtier externe (16) opposée à la première extrémité (30) le long de l'axe longitudinal (X), la cavité (28) comprenant longitudinalement une première section (38) qui s'élargit transversalement à partir de la première extrémité (30) vers la seconde extrémité (32), ainsi qu'une seconde section (40) qui se rétrécit transversalement vers la seconde extrémité (32),
- insertion de l'ensemble interne (15) dans la cavité (28) le long de l'axe longitudinal (X) à travers l'ouverture (18), et
- pendant ou avant ladite étape d'insertion, déplacement élastique de la partie flexible (54) par rapport à la partie principale (52) entre une configuration de repos, dans laquelle l'ensemble interne (15) a une première extension (E3) le long d'un axe transversal (Z) perpendiculaire à l'axe longitudinal (X) qui est plus grande qu'une extension (E1) de l'ouverture (18) le long de l'axe transversal (Z), et une configuration fléchie ou rétractée, dans laquelle l'ensemble interne (15) présente une deuxième extension (E3) le long de l'axe transversal (Z) qui est inférieure à l'extension (E1) de l'ouverture (18), de manière à permettre ladite insertion.
